# EUROPÄISCHE PATENTSCHRIFT

(11) **EP 4 094 360 B1**
(45) Veröffentlichungstag und Bekanntmachung des Hinweises auf die Patenterteilung: **09.04.2025**
(21) Anmeldenummer: 21700164.3
(22) Anmeldetag: 05.01.2021
(51) Int. Cl.: H03K 17/96

(54) **VERFAHREN UND SYSTEM ZUR DYNAMISCHEN KALIBRIERUNG VON KAPAZITIVEN TOUCH-BEDIENELEMENTEN IN BEZUG AUF VERSCHIEDENE UMWELTEINFLÜSSE**
METHOD AND SYSTEM FOR DYNAMICALLY CALIBRATING CAPACITIVE TOUCH OPERATING ELEMENTS IN RELATION TO VARIOUS ENVIRONMENTAL INFLUENCES
PROCÉDÉ ET SYSTÈME D'ÉTALONNAGE DYNAMIQUE D'ÉLÉMENTS TACTILES CAPACITIFS PAR RAPPORT À DIVERSES INFLUENCES ENVIRONNEMENTALES

(30) Priorität: 22.01.2020 DE 102020200744
(43) Veröffentlichungstag der Anmeldung: 30.11.2022
(73) Patentinhaber: VOLKSWAGEN AKTIENGESELLSCHAFT, 38440 Wolfsburg (DE)
(72) Erfinder: ROSILIUS, Marcel, 38104 Braunschweig (DE)
(86) Internationale Anmeldenummer: PCT/EP2021/050056
(87) Internationale Veröffentlichungsnummer: WO 2021/148246

(56) Entgegenhaltungen:
- EP-B1- 3 473 498
- DE-A1- 102017 208 221
- DE-A1- 102018 209 576

## Beschreibung

Die Erfindung betrifft ein Verfahren und ein System zur dynamischen Kalibrierung von kapazitiven Touch-Bedienelementen in Bezug auf verschiedene Umwelteinflüsse.

Interaktionen zwischen Menschen und den unterschiedlichsten technischen Geräten werden häufig über zu bedienende Schaltelemente ausgeübt. Solche Schaltelemente können dabei die verschiedensten Formen und Funktionsweisen umfassen. Ein besonderes Schaltelement beziehungsweise allgemein ausgedrückt ein Bedienelement sind die sogenannten Touch-Bedienelemente, bei denen eine Interaktion über eine berührungsempfindliche Oberfläche an dem Gerät, meist in Form eines berührungsempfindlichen Bildschirms, realisiert wird. Wie für jegliche andere Schaltelemente auch, besteht eine Grundbedingung dieser Touch-Bedienelemente darin, dass sie unter allen Bedingungen perfekt funktionieren sollen und vor allem jegliche Benutzereingaben erkennen sollen. Des Weiteren sollen solche Bedienelemente auch dann bedienbar sein, wenn ein Anwender beispielsweise Handschuhe trägt. Auch soll eine zuverlässige Bedienweise selbst dann gewährleistet sein, wenn beispielsweise Wassertropfen präsent sind. Dies kann sich zum Beispiel auf einem Bedienelement im Bereich einer Tür eines Kraftfahrzeugs ereignen. In diesem Zusammenhang sind bereits erste Lösungsansätze bekannt. So wird etwa die Sensitivität des Bauteils erhöht, sodass auch ein Finger oder allgemein ein Körperteil erkannt werden kann, der von Stoff oder Leder umhüllt ist. Um Fehlauslösungen durch Wassertropfen oder dergleichen zu verhindern, muss eine teilweise komplexe Logik im Bauteil integriert werden, die ermittelt, ob es sich wahrscheinlicher um einen Wassertropfen oder einen Finger handelt. Als nachteilig kann dabei etwa empfunden werden, dass durch Erhöhung der Sensitivität der Touch-Sensor schon vor Berührung der Fläche eine Auslösung erkennt. Dadurch wird die Gefahr einer Fehlauslösung oder eines unerwarteten Verhaltens erhöht. Zudem kann aufgrund der zuvor genannten komplexen Logik die Erkennung von gewollten Eingaben reduziert werden. Um diesen Problemen zu begegnen, wird heutzutage häufig ein Kompromiss zwischen einer vorzeitigen Auslösung und einer Handschuhbedienbarkeit gewählt. Auch wird ein Kompromiss zwischen einer verminderten Fehlauslösung etwa durch Wassertropfen und einer zuverlässigen Bedienbarkeit gewählt. Nachfolgend wird ein Beispiel aus dem Stand der Technik vorgestellt.

DE 10 2017 208 221 A1 offenbart eine Steuervorrichtung für ein Fahrzeug mit automatisch öffnender und/oder automatisch schließender Klappe. Hierbei wird ein Verfahren zur Adaption eines Näherungssensors eingesetzt, bei der aktuelle Umwelteinflüsse berücksichtigt werden.

DE10 2018 209 576 A1 offenbart ein Benutzer-Schnittstellensystem zum Steuern eines Fahrzeugbetriebs. Eine gedruckte Leiterplatte ist mit einem Näherungssensor und einer Licht emittierenden Vorrichtung kombiniert.

So ist aus der Druckschrift DE 10 2012 209 356 A1 ein Näherungsschalter mit erlernter Empfindlichkeit und ein Verfahren dafür als bekannt zu entnehmen. Insbesondere werden ein Fahrzeugnäherungsschalter und ein Verfahren mit Steuerung für erlernte Empfindlichkeit bereitgestellt. Der Schalter umfasst einen Näherungssensor, wie zum Beispiel einen kapazitiven Sensor, der in einem Fahrzeug eingebaut ist und ein Erfassungsaktivierungsfeld bereitstellt. Auch enthalten ist eine Erfassungssteuerungsschaltungsanordnung, die das Aktivierungsfeld bearbeitet, um durch Vergleich des Aktivierungsfelds mit einem Schwellenwert eine Benutzeraktivierung des Schalters zu erfassen. Der Schalter umfasst weiter eine Empfindlichkeitssteuerungsschaltungsanordnung, die eine Benutzerempfindlichkeit auf Basis von Benutzeraktivierung eines Sensors erlernt und die Empfindlichkeit eines oder mehrerer Näherungsschalter steuert.

Der Erfindung liegt nun die Aufgabe zugrunde, ein alternatives Verfahren und System bereitzustellen, welche eine effiziente und zuverlässige Kalibrierung von kapazitiven Touch-Bedienelementen in Bezug auf verschiedene Umwelteinflüsse gewährleisten.

In bevorzugter Ausgestaltung der Erfindung ist vorgesehen, dass ein Verfahren zur dynamischen Kalibrierung von kapazitiven Touch-Bedienelementen in Bezug auf verschiedene Umwelteinflüsse bereitgestellt wird. Solch ein Verfahren umfasst dabei die folgenden Schritte: Bereitstellen wenigstens eines mit einer Steuer- und Recheneinheit mit Bedienprogramm gekoppelten Touch-Bedienelements, Bereitstellen wenigstens von zwei sich unterscheidenden und jeweils mit der Steuer- und Recheneinheit mit Bedienprogramm gekoppelten Umweltsensoren, wobei die Steuer- und Recheneinheit mit Bedienprogramm ausgelegt ist, zumindest eine Kalibrierung einer Bedienweise des wenigstens einen Touch-Bedienelements festzulegen. Ferner umfasst das Verfahren die folgenden weiteren Schritte: Messen von wenigstens zwei sich unterscheidenden Umwelteinflüssen mittels der wenigstens zwei Umweltsensoren in einem Umfeld des Touch-Bedienelements, Bereitstellen der gemessenen Werte über die wenigstens zwei Umwelteinflüsse an die Steuer- und Recheneinheit mit Bedienprogramm, Auswählen eines gemäß den gemessenen Werten über die wenigstens zwei Umwelteinflüsse optimalen Kalibrierung der Bedienweise des wenigstens einen Touch-Bedienelements mittels der Steuer- und Recheneinheit mit Bedienprogramm, sodass das wenigstens eine Touch-Bedienelement in einem bezogen auf die aktuellen Umwelteinflüsse optimalen Arbeitsbereich bereitgestellt wird. Durch Einbeziehen der Umwelteinflüsse um das Touch-Bedienelement herum kann dieses Touch-Bedienelement immer im optimalen Arbeitsbereich funktionieren. Es ist bei der Umsetzung nicht relevant, ob alle oder nur ausgewählte Umwelteinflüsse bei der Funktionalität des Touch-Bedienelements einbezogen werden. Mittels des vorgestellten Verfahrens ist es jedoch möglich, möglichst viele Informationen beziehungsweise Daten über Umwelteinflüsse in dem Umfeld des Touch-Bedienelements indirekt über die Steuer- und Recheneinheit an das Touch-Bedienelement zu übermitteln und somit Arbeitsbereiche zu definieren, in denen das Bedienelement seine Funktionen einschränkt, die Parametrierung einschränkt oder in spezielle Betriebsmodi schaltet, wobei diese Vorgänge entsprechend von der Steuer- und Recheneinheit beziehungsweise mit dem Bedienprogramm bedingt werden. Es erfolgt somit eine intelligente Kalibrierung. Es muss kein manueller Anlernvorgang gestartet werden, sondern das Touch-Bedienelement wird mit diversen Umwelteinflussinformationen beziehungsweise mit Informationen beziehungsweise Daten über Umwelteinflüsse versorgt. Dabei berechnet die Steuer- und Recheneinheit dann entsprechend aus den verschiedenen Einflüssen einen dann optimalen Arbeitsbereich, wobei auch eine gewisse Auslöseschwelle für das Touch-Bedienelement bestimmt wird. Es wird somit ein breites Spektrum an Umwelteinflüssen abgedeckt und mittels des vorgestellten Verfahrens kann dann intelligent und individuell auf alle möglichen Umwelteinflüsse dynamisch reagiert werden, sodass immer ein optimaler Arbeitsbereich für das Touch-Bedienelement eingestellt wird.

Erfindungsgemäß ist ferner vorgesehen, dass das Verfahren die folgenden weiteren Schritte umfasst: Erheben einer GPS-Position eines Fahrzeuges, in welchem das wenigstens eine Touch-Bedienelement, die wenigstens zwei Umweltsensoren und die Steuer- und Recheneinheit mit Bedienprogramm angeordnet sind, Bereitstellen dieser Information über die erhobene GPS-Position an die Steuer- und Recheneinheit mit Bedienprogramm, sodass diese Informationen bei der optimalen Kalibrierung berücksichtigt werden, sodass das wenigstens eine Touch-Bedienelement in einem bezogen auf die aktuellen Umwelteinflüsse und bezogen auf die erhobene GPS-Position optimalen Arbeitsbereich bereitgestellt wird. Allgemeine Klimabedingungen von dem Land, in dem das Fahrzeug betrieben wird, können somit zuverlässig in dem vorgestellten Verfahren für die Auswahl eines optimalen Arbeitsbereichs berücksichtigt werden.

In weiterer bevorzugter Ausgestaltung der Erfindung ist vorgesehen, dass ein System zur dynamischen Kalibrierung von kapazitiven Touch-Bedienelementen in Bezug auf verschiedene Umwelteinflüsse bereitgestellt wird. Solch ein System umfasst dabei wenigstens ein mit einer Steuer- und Recheneinheit mit Bedienprogramm gekoppeltes Touch-Bedienelement, wenigstens zwei sich unterscheidende und jeweils mit der Steuer- und Recheneinheit mit Bedienprogramm gekoppelte Umweltsensoren, wobei die Steuer- und Recheneinheit mit Bedienprogramm ausgelegt ist, zumindest eine Kalibrierung einer Bedienweise des wenigstens einen Touch-Bedienelements festzulegen. Das System ist dabei ausgelegt, mittels der wenigstens zwei Umweltsensoren in einem Umfeld des Touch-Bedienelements wenigstens zwei sich unterscheidende Umwelteinflüsse zu messen, sodass diese gemessenen Werte über die wenigstens zwei Umwelteinflüsse der Steuer- und Recheneinheit mit Bedienprogramm bereitstellbar sind, sodass gemäß den gemessenen Werten über die wenigstens zwei Umwelteinflüsse eine optimale Kalibrierung der Bedienweise des wenigstens einen Touch-Bedienelements mittels der Steuer- und Recheneinheit mit Bedienprogramm auswählbar ist, sodass das wenigstens eine Touch-Bedienelement in einem bezogen auf die aktuellen Umwelteinflüsse optimalen Arbeitsbereich bereitstellbar ist. Die zuvor genannten Vorteile gelten soweit übertragbar auch für das vorgestellte System.

Weitere bevorzugte Ausgestaltungen der Erfindung ergeben sich aus den übrigen, in den Unteransprüchen genannten Merkmalen.

So ist in einer weiteren Ausgestaltung der Erfindung vorgesehen, dass das wenigstens eine Touch-Bedienelement und die wenigstens zwei Umweltsensoren und die Steuer- und Recheneinheit mit Bedienprogramm in einem Fahrzeug, insbesondere in einem Kraftfahrzeug, angeordnet sind. Auf diese Weise kann durch Einbeziehen der Umwelteinflüsse um das Touch-Bedienelement herum dieses Touch-Bedienelement in dem Fahrzeug immer im optimalen Arbeitsbereich funktionieren. So ist es beispielsweise im Sommer, bei 30 °C Außentemperatur sehr unwahrscheinlich, dass der Kunde beispielsweise in ein Fahrzeug mit Handschuhen einsteigt. Wenn die Außentemperatur < 0 °C ist, ist die Chance hingegen sehr hoch. Wird beispielsweise eine Innentemperatur während einer längeren Fahrt angehoben steigt damit die Chance, dass der Anwender die Handschuhe auszieht und das Touch-Bedienelement wieder ohne Handschuhe bedient. Da das vorgestellte Verfahren jeweilige sich neu einstellenden Umwelteinflüsse intelligent und individuell berücksichtigt, um dynamisch dann den jeweils besten Arbeitsbereich einzustellen, stellen auch häufig wechselnde Fahrer mit den damit einhergehenden individuellen Umwelteinflüssen kein Problem mehr dar. Es kann somit auch bei häufig wechselnden Fahrern davon ausgegangen werden, dass mittels des vorgestellten Verfahrens stets eine optimale Bedienweise des Touch-Bedienelements möglich ist. Genauso wird mittels des Verfahrens beispielsweise bei einer längeren Fahrt mit einer erhöhten Innenraumtemperatur erkannt beziehungsweise folgerichtige geschlussfolgert, dass eventuell vorhandene Handschuhe ausgezogen werden und somit eine Sensitivität des Touch-Bedienelements beziehungsweise eines Sensors von diesem gesenkt werden kann.

Auch ist in einer weiteren Ausgestaltung der Erfindung vorgesehen, dass das wenigstens eine Touch-Bedienelement und die wenigstens zwei Umweltsensoren in einem Elektronikgerät angeordnet sind. Die zuvor genannten Vorteile gelten soweit übertragbar auch für diese Ausführungsvariante der Erfindung.

Ferner ist in einer weiteren Ausgestaltung der Erfindung vorgesehen, dass einer der wenigstens zwei Umweltsensoren Temperaturwerte in dem Umfeld misst und wobei einer der wenigstens zwei Umweltsensoren Luftfeuchtigkeitswerte in dem Umfeld misst. Auf diese Weise werden sehr effizient und zuverlässig zumindest zwei sich unterscheidende Umwelteinflüsse für das vorgestellte Verfahren berücksichtigt, sodass stets ein optimaler Arbeitsbereich an dem Touch-Bedienelement vorgesehen wird.

Zudem ist in einer weiteren Ausgestaltung der Erfindung vorgesehen, dass einer der wenigstens zwei Umweltsensoren Temperaturwerte in dem Umfeld misst und entweder an dem wenigstens einen Touch-Bedienelement und/oder in einem Innenbereich eines Fahrzeugs angeordnet ist. Soweit wie möglich können somit die Daten mittels eines Umweltsensors am Touch-Bedienelement selbst ermittelt werden, wobei beispielsweise ein Temperatursensor auf dem Touch-Bedienelement oder einer Platine davon angeordnet ist. Zur Erhöhung der Genauigkeit sind jedoch zusätzliche Daten und Informationen aus dem Fahrzeug hilfreich und zu bevorzugen, sodass beispielsweise ein Umweltsensor in der Form eines Innentemperatursensors für diese Zwecke vorgesehen wird.

Auch ist in einer weiteren Ausgestaltung der Erfindung vorgesehen, dass das Verfahren die folgenden weiteren Schritte umfasst: Erheben folgender Merkmale eines jeweiligen Anwenders des wenigstens einen Touch-Bedienelements: Alter, Geschlecht, Größe, insbesondere mittels einer Fahrerbeobachtungskamera, Bereitstellen dieser Informationen über die Merkmale an die Steuer- und Recheneinheit mit Bedienprogramm, sodass diese Informationen bei der optimalen Kalibrierung berücksichtigt werden, sodass das wenigstens eine Touch-Bedienelement in einem bezogen auf die aktuellen Umwelteinflüsse und bezogen auf die erhobenen Merkmale des Anwenders optimalen Arbeitsbereich bereitgestellt wird. Kapazitive Eigenschaften der Finger, welche in erster Linie für die Bedienung von Touch-Bedienelementen eingesetzt werden, unterscheiden sich durch Alter, Geschlecht und Größe (Fingerdurchmesser, Hautfeuchtigkeit). Somit können diese Umstände in dem vorgestellten Verfahren optimal eingesetzt und verwendet werden, um einen individuell optimalen Arbeitsbereich bereitzustellen.

Zudem ist in einer weiteren Ausgestaltung der Erfindung vorgesehen, dass das Verfahren die folgenden weiteren Schritte umfasst: Abfragen eines Status eines Regen-Licht-Sensorelements eines Fahrzeugs, in welchem das wenigstens eine Touch-Bedienelement, die wenigstens zwei Umweltsensoren und die Steuer- und Recheneinheit mit Bedienprogramm angeordnet sind, Bereitstellen dieser Information über den aktuellen Status des Regen-Licht-Sensorelements des Fahrzeugs an die Steuer- und Recheneinheit mit Bedienprogramm, sodass diese Informationen bei der optimalen Kalibrierung berücksichtigt werden, sodass das wenigstens eine Touch-Bedienelement in einem bezogen auf die aktuellen Umwelteinflüsse und bezogen auf die erhobenen Merkmale des Anwenders optimalen Arbeitsbereich bereitgestellt wird. Wenn es draußen nicht regnet, ist es ebenso unwahrscheinlich, dass beim Einsteigen in das Fahrzeug Wassertropfen auf das Touch-Bedienelement kommen. Insofern kann über den entsprechenden Status des Regen-Licht-Sensorelements eine gewisse Vorauswahl der optimalen Arbeitsbereiche getroffen werden und in Verbindung mit weiteren ermittelten beziehungsweise erhobenen Umwelteinflüssen noch weiter optimiert werden.

Schlussendlich ist in einer weiteren Ausgestaltung der Erfindung vorgesehen, dass die Steuer- und Recheneinheit mit Bedienprogramm, zumindest teilweise benutzerdefiniert einstellbar ist, sodass jeweilige zusammen erhobene Umwelteinflüsse benutzerdefiniert jeweiligen optimalen Arbeitsbereichen zuordenbar sind. Die zuvor genannten Vorteile sind somit noch besser zu erreichen.

Die verschiedenen in dieser Anmeldung genannten Ausführungsformen der Erfindung sind, sofern im Einzelfall nicht anders ausgeführt, mit Vorteil miteinander kombinierbar.

Die Erfindung wird nachfolgend in Ausführungsbeispielen anhand der zugehörigen Zeichnungen erläutert. Es zeigen:
- Figur 1: ein Verfahrensablaufdiagramm von einem Verfahren zur dynamischen Kalibrierung von kapazitiven Touch-Bedienelementen in Bezug auf verschiedene Umwelteinflüsse;
- Figur 2: eine schematische Darstellung von einem System zur dynamischen Kalibrierung von kapazitiven Touch-Bedienelementen in Bezug auf verschiedene Umwelteinflüsse.

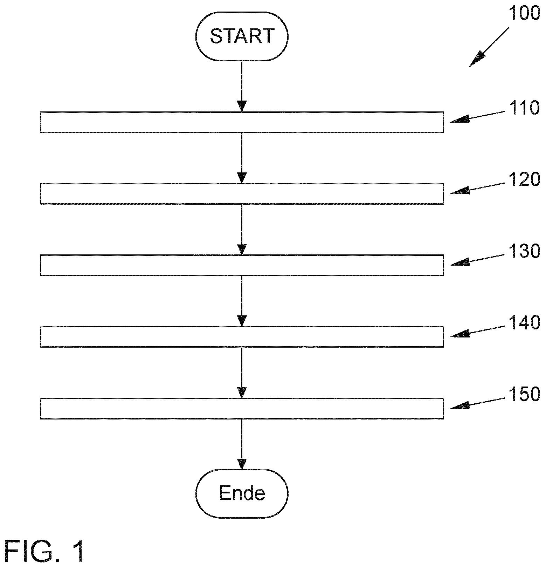

Figur 1 zeigt ein Verfahrensablaufdiagramm 100 von einem Verfahren zur dynamischen Kalibrierung von kapazitiven Touch-Bedienelementen 12 in Bezug auf verschiedene Umwelteinflüsse. In einem ersten Verfahrensschritt 110 wird wenigstens ein mit einer Steuer- und Recheneinheit 14 mit Bedienprogramm 16 gekoppeltes Touch-Bedienelement 12 bereitgestellt. In einem zweiten Verfahrensschritt 120 werden wenigstens zwei sich unterscheidende und jeweils mit der Steuer- und Recheneinheit 14 mit Bedienprogramm 16 gekoppelte Umweltsensoren 18, 20 bereitgestellt, wobei die Steuer- und Recheneinheit 14 mit Bedienprogramm 16 ausgelegt ist, zumindest eine Kalibrierung einer Bedienweise des wenigstens einen Touch-Bedienelements 12 festzulegen. In einem dritten Verfahrensschritt 130 werden wenigstens zwei sich unterscheidende Umwelteinflüsse mittels der wenigstens zwei Umweltsensoren 18, 20 in einem Umfeld des Touch-Bedienelement 12 gemessen. In einem vierten Verfahrensschritt 140 werden die gemessenen Werte über die wenigstens zwei Umwelteinflüsse an die Steuer- und Recheneinheit 14 mit Bedienprogramm 16 bereitgestellt. In einem fünften Verfahrensschritt 150 wird gemäß den gemessenen Werten über die wenigstens zwei Umwelteinflüsse eine optimale Kalibrierung der Bedienweise des wenigstens einen Touch-Bedienelements 12 mittels der Steuer- und Recheneinheit 14 mit Bedienprogramm 16 ausgewählt, sodass das wenigstens eine Touch-Bedienelement 12 in einem bezogen auf die aktuellen Umwelteinflüsse optimalen Arbeitsbereich bereitgestellt wird.

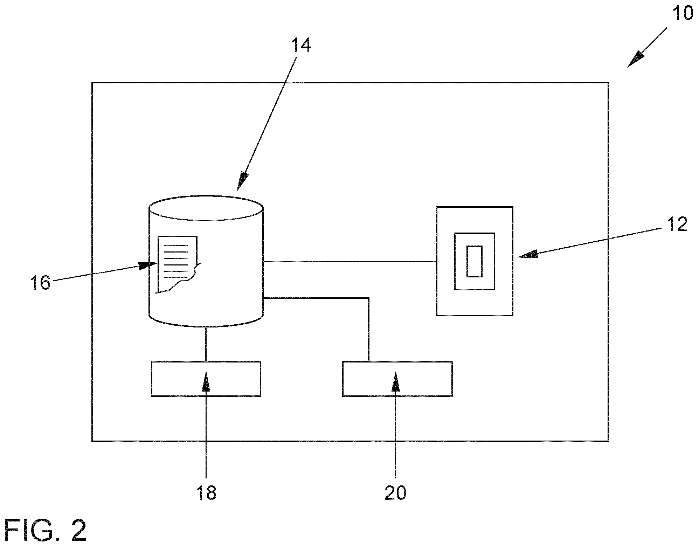

Figur 2 zeigt eine schematische Darstellung von einem System 10 zur dynamischen Kalibrierung von kapazitiven Touch-Bedienelementen 12 in Bezug auf verschiedene Umwelteinflüsse. Dabei ist das System 10 mit einem mit einer Steuer- und Recheneinheit 14 mit Bedienprogramm 16 gekoppelten Touch-Bedienelement 12 dargestellt. In einer nicht näher dargestellten Variante des Systems 10 ist es vorstellbar, dass mehr als ein Touch-Bedienelement 12 vorgesehen sind, wobei jedes dieser Touch-Bedienelemente 12 dann jeweilig mit der Steuer- und Recheneinheit 14 mit Bedienprogramm 16 koppelbar ist. Zudem ist das System 10 mit zwei sich unterscheidenden und jeweils mit der Steuer- und Recheneinheit 14 mit Bedienprogramm 16 gekoppelten Umweltsensoren 18, 20 dargestellt, wobei die Steuer- und Recheneinheit 14 mit Bedienprogramm 16 ausgelegt ist, zumindest eine Kalibrierung einer Bedienweise des Touch-Bedienelements 12 festzulegen. In einer nicht näher dargestellten Variante des Systems 10 ist es vorstellbar, dass mehr als zwei Umweltsensoren 18, 20 vorgesehen sind. Beispielsweise ist in dem dargestellten Ausführungsbeispiel der erste Umweltsensor 18 zumindest ausgelegt, eine Temperatur in einem Umfeld von dem Touch-Bedienelementen 12 zu messen und der zweite Umweltsensor 20 ist zumindest ausgelegt, eine Luftfeuchtigkeit in dem Umfeld von den Touch-Bedienelementen 12 zu messen. Das dargestellte System 10 ist dabei ausgelegt, mittels der wenigstens zwei Umweltsensoren 18, 20 in einem Umfeld des Touch-Bedienelements 12 wenigstens zwei sich unterscheidende Umwelteinflüsse zu messen, sodass diese gemessenen Werte über die wenigstens zwei Umwelteinflüsse der Steuer- und Recheneinheit 14 mit Bedienprogramm 16 bereitstellbar sind, sodass gemäß den gemessenen Werten über die wenigstens zwei Umwelteinflüsse eine optimale Kalibrierung der Bedienweise des wenigstens einen Touch-Bedienelements 12 mittels der Steuer- und Recheneinheit 14 mit Bedienprogramm 16 auswählbar ist, sodass das wenigstens eine Touch-Bedienelement 12 in einem bezogen auf die aktuellen Umwelteinflüsse optimalen Arbeitsbereich bereitstellbar ist.

### Bezugszeichenliste

- 10: System
- 12: Touch-Bedienelement
- 14: Steuer- und Recheneinheit
- 16: Bedienprogramm
- 18: erster Umweltsensor
- 20: zweiter Umweltsensor
- 100: Verfahrensablaufdiagramm
- 110: erster Verfahrensschritt
- 120: zweiter Verfahrensschritt
- 130: dritter Verfahrensschritt
- 140: vierter Verfahrensschritt
- 150: fünfter Verfahrensschritt

## Patentansprüche

1. Verfahren zur dynamischen Kalibrierung von kapazitiven Touch-Bedienelementen (12) in Bezug auf verschiedene Umwelteinflüsse umfassend die folgenden Schritte:
• Bereitstellen wenigstens eines mit einer Steuer- und Recheneinheit (14) mit Bedienprogramm (16) gekoppelten Touch-Bedienelements (12);
• Bereitstellen wenigstens von zwei sich unterscheidenden und jeweils mit der Steuer- und Recheneinheit (14) mit Bedienprogramm (16) gekoppelten Umweltsensoren (18, 20), wobei die Steuer- und Recheneinheit (14) mit Bedienprogramm (16) ausgelegt ist, zumindest eine Kalibrierung des wenigstens einen Touch-Bedienelements (12) festzulegen, wobei das das Verfahren die folgenden weiteren Schritte umfasst:
• Messen von wenigstens zwei sich unterscheidenden Umwelteinflüssen mittels der wenigstens zwei Umweltsensoren (18, 20) in einem Umfeld des Touch-Bedienelement, (12);
• Bereitstellen der gemessenen Werte über die wenigstens zwei Umwelteinflüsse an die Steuer- und Recheneinheit (14) mit Bedienprogramm (16);
• Auswählen einer gemäß den gemessenen Werten über die wenigstens zwei Umwelteinflüsse Kalibrierung des wenigstens einen Touch-Bedienelements (12) mittels der Steuer- und Recheneinheit (14) mit Bedienprogramm (16), sodass das wenigstens eine Touch-Bedienelement (12) in einem bezogen auf die aktuellen Umwelteinflüsse individuellen Arbeitsbereich bereitgestellt wird,
• Erheben einer GPS-Position eines Fahrzeuges, in welchem das wenigstens eine Touch-Bedienelement (12), die wenigstens zwei Umweltsensoren (18, 20) und die Steuer- und Recheneinheit (14) mit Bedienprogramm (16) angeordnet sind;
• Bereitstellen dieser Information über die erhobene GPS-Position an die Steuer- und Recheneinheit (14) mit Bedienprogramm (16), sodass diese Informationen bei der Kalibrierung berücksichtigt werden, sodass das wenigstens eine Touch-Bedienelement (12) in einem bezogen auf die aktuellen Umwelteinflüsse und bezogen auf die erhobene GPS-Position individuellen Arbeitsbereich bereitgestellt wird.

2. Verfahren nach Anspruch 1, wobei das wenigstens eine Touch-Bedienelement (12) und die wenigstens zwei Umweltsensoren (18, 20) und die Steuer- und Recheneinheit (14) mit Bedienprogramm (16) in einem Fahrzeug, insbesondere in einem Kraftfahrzeug, angeordnet sind.

3. Verfahren nach Anspruch 1, wobei das wenigstens eine Touch-Bedienelement (12) und die wenigstens zwei Umweltsensoren (18, 20) in einem Elektronikgerät angeordnet sind.

4. Verfahren nach einem der vorherigen Ansprüche, wobei einer der wenigstens zwei Umweltsensoren (18, 20) Temperaturwerte in dem Umfeld misst und wobei einer der wenigstens zwei Umweltsensoren (18, 20) Luftfeuchtigkeitswerte in dem Umfeld misst.

5. Verfahren nach Anspruch 4, wobei einer der wenigstens zwei Umweltsensoren (18, 20) Temperaturwerte in dem Umfeld misst und entweder an dem wenigstens einen Touch-Bedienelement (12) und/oder in einem Innenbereich eines Fahrzeugs angeordnet ist.

6. Verfahren nach einem der vorherigen Ansprüche 1 bis 2 oder 4 bis 5, wobei das Verfahren die folgenden weiteren Schritte umfasst:
• Erheben folgender Merkmale eines jeweiligen Anwenders des wenigstens einen Touch-Bedienelements (12): Alter, Geschlecht, Größe, mittels einer Fahrerbeobachtungskamera;
• Bereitstellen dieser Informationen über die Merkmale an die Steuer- und Recheneinheit (14) mit Bedienprogramm (16), sodass diese Informationen bei der Kalibrierung berücksichtigt werden, sodass das wenigstens eine Touch-Bedienelement (12) in einem bezogen auf die aktuellen Umwelteinflüsse, die erhobene GPS-Position und bezogen auf die erhobenen Merkmale des Anwenders individuellen Arbeitsbereich bereitgestellt wird.

7. Verfahren nach einem der vorherigen Ansprüche 1 bis 2 oder 4 bis 6, wobei das Verfahren die folgenden weiteren Schritte umfasst:
• Abfragen eines Status eines Regen-Licht-Sensorelements eines Fahrzeugs, in welchem das wenigstens eine Touch-Bedienelement (12), die wenigstens zwei Umweltsensoren (18, 20) und die Steuer- und Recheneinheit (14) mit Bedienprogramm (16) angeordnet sind;
• Bereitstellen dieser Information über den aktuellen Status des Regen-Licht-Sensorelements des Fahrzeugs an die Steuer- und Recheneinheit (14) mit Bedienprogramm (16), sodass diese Informationen bei der Kalibrierung berücksichtigt werden, sodass das wenigstens eine Touch-Bedienelement (12) in einem bezogen auf die aktuellen Umwelteinflüsse, die erhobene GPS-Position und bezogen auf die erhobenen Merkmale des Anwenders individuellen Arbeitsbereich bereitgestellt wird.

8. Verfahren nach einem der vorherigen Ansprüche, wobei die Steuer- und Recheneinheit (14) mit Bedienprogramm (16), zumindest teilweise benutzerdefiniert einstellbar ist, sodass jeweilige zusammen erhobene Umwelteinflüsse benutzerdefiniert jeweiligen individuellen Arbeitsbereichen zuordenbar sind.

9. System (10) zur dynamischen Kalibrierung von kapazitiven Touch-Bedienelementen (12) in Bezug auf verschiedene Umwelteinflüsse umfassend wenigstens ein mit einer Steuer- und Recheneinheit (14) mit Bedienprogramm (16) gekoppelten Touch-Bedienelement (12), wenigstens zwei sich unterscheidenden und jeweils mit der Steuer- und Recheneinheit (14) mit Bedienprogramm (16) gekoppelten Umweltsensoren (18, 20), wobei die Steuer- und Recheneinheit (14) mit Bedienprogramm (16) ausgelegt ist, zumindest eine Kalibrierung des wenigstens einen Touch-Bedienelements (12) festzulegen, wobei das System (10) ausgelegt ist, mittels der wenigstens zwei Umweltsensoren (18, 20) in einem Umfeld des Touch-Bedienelements (12) wenigstens zwei sich unterscheidende Umwelteinflüsse zu messen, sodass diese gemessenen Werte über die wenigstens zwei Umwelteinflüsse der Steuer- und Recheneinheit (14) mit Bedienprogramm (16) bereitstellbar sind, sodass gemäß den gemessenen Werten über die wenigstens zwei Umwelteinflüsse eine Kalibrierung des wenigstens einen Touch-Bedienelements (12) mittels der Steuer- und Recheneinheit (14) mit Bedienprogramm (16) auswählbar ist, sodass das wenigstens eine Touch-Bedienelement (12) in einem bezogen auf die aktuellen Umwelteinflüsse individuellen Arbeitsbereich bereitstellbar ist, das System (10) zusätzlich ausgelegt ist, eine GPS-Position eines Fahrzeuges zu erheben, und die Information über die erhobene GPS-Information an die Steuer- und Recheneinheit (14) mit Bedienprogramm (16) bereitstellbar ist, sodass die GPS-Position bei der Bereitstellung des individuellen Arbeitsbereichs des Touch-Bedienelementes (12) berücksichtigbar ist.

## Claims

1. Method for dynamically calibrating capacitive touch-control elements (12) with respect to various environmental influences, comprising the following steps:
• providing at least one touch-control element (12) coupled to a control and computing unit (14) with an operating program (16);
• providing at least two different environmental sensors (18, 20) each coupled to the control and computing unit (14) with operating program (16), wherein the control and computing unit (14) with operating program (16) is designed to determine at least one calibration of the at least one touch-control element (12), wherein the method comprises the following further steps:
• measuring at least two different environmental influences by means of the at least two environmental sensors (18, 20) in an environment of the touch-control element (12);
• providing the measured values of the at least two environmental influences to the control and computing unit (14) with operating program (16);
• selecting a calibration of the at least one touch-control element (12) according to the measured values of the at least two environmental influences by means of the control and computing unit (14) with operating program (16), so that the at least one touch-control element (12) is provided in an individual working region in relation to the current environmental influences,
• collecting a GPS position of a vehicle in which the at least one touch-control element (12), the at least two environmental sensors (18, 20) and the control and computing unit (14) with operating program (16) are arranged;
• providing this information about the collected GPS position to the control and computing unit (14) with operating program (16) so that this information is taken into account during calibration, so that the at least one touch-control element (12) is provided in an individual working region in relation to the current environmental influences and in relation to the collected GPS position.

2. Method according to claim 1, wherein the at least one touch-control element (12) and the at least two environmental sensors (18, 20) and the control and computing unit (14) with operating program (16) are arranged in a vehicle, in particular in a motor vehicle.

3. Method according to claim 1, wherein the at least one touch-control element (12) and the at least two environmental sensors (18, 20) are arranged in an electronic device.

4. Method according to any of the preceding claims, wherein one of the at least two environmental sensors (18, 20) measures temperature values in the environment and wherein one of the at least two environmental sensors (18, 20) measures humidity values in the environment.

5. Method according to claim 4, wherein one of the at least two environmental sensors (18, 20) measures temperature values in the environment and is arranged either on the at least one touch-control element (12) and/or in an interior region of a vehicle.

6. Method according to any of the preceding claims 1 to 2 or 4 to 5, wherein the method comprises the following further steps:
• collecting following characteristics of a particular user of the at least one touch-control element (12): age, gender, height, by means of a driver observation camera;
• providing this information about the characteristics to the control and computing unit (14) with operating program (16) so that this information is taken into account during calibration, so that the at least one touch-control element (12) is provided in an individual working region based on the current environmental influences, the collected GPS position and based on the collected characteristics of the user.

7. Method according to any of the preceding claims 1 to 2 or 4 to 6, wherein the method comprises the following further steps:
• querying a status of a rain-light sensor element of a vehicle in which the at least one touch-control element (12), the at least two environmental sensors (18, 20) and the control and computing unit (14) with operating program (16) are arranged;
• providing this information about the current status of the rain-light sensor element of the vehicle to the control and computing unit (14) with operating program (16) so that this information is taken into account during calibration, so that the at least one touch-control element (12) is provided in an individual working region based on the current environmental influences, the collected GPS position and based on the collected characteristics of the user.

8. Method according to any of the preceding claims, wherein the control and computing unit (14) with operating program (16) is at least partially adjustable in a user-defined manner, so that respective environmental influences collected together can be assigned to respective individual working regions in a user-defined manner.

9. System (10) for dynamically calibrating capacitive touch-control elements (12) with respect to various environmental influences, comprising at least one touch-control element (12) coupled to a control and computing unit (14) with an operating program (16), at least two different environmental sensors (18, 20) each coupled to the control and computing unit (14) with operating program (16), wherein the control and computing unit (14) with operating program (16) is designed to determine at least one calibration of the at least one touch-control element (12), wherein the system (10) is designed to measure at least two different environmental influences in an environment of the touch-control element (12) by means of the at least two environmental sensors (18, 20), so that these measured values can be provided to the control and computing unit (14) with operating program (16) via the at least two environmental influences, so that according to the measured values of the at least two environmental influences, a calibration of the at least one touch-control element (12) can be selected by means of the control and computing unit (14) with operating program (16), so that the at least one touch-control element (12) can be provided in an individual working region based on the current environmental influences, the system (10) is additionally designed to collect a GPS position of a vehicle, and the information about the collected GPS information can be provided to the control and computing unit (14) with operating program (16) so that the GPS position can be taken into account when providing the individual working region of the touch-control element (12).

## Revendications

1. Procédé permettant le calibrage dynamique d'éléments de manipulation tactiles (12) capacitifs par rapport à différentes influences environnementales, comprenant les étapes suivantes :
• mise à disposition d'au moins un élément de manipulation tactile (12) couplé à une unité de commande et de calcul (14) comportant un programme de manipulation (16) ;
• mise à disposition d'au moins deux capteurs environnementaux (18, 20) distincts et respectivement couplés à l'unité de commande et de calcul (14) comportant un programme de manipulation (16), dans lequel l'unité de commande et de calcul (14) comportant un programme de manipulation (16) est configurée pour déterminer au moins un calibrage de l'au moins un élément de manipulation tactile (12), dans lequel le procédé comprend les étapes supplémentaires suivantes :
• mesure d'au moins deux influences environnementales distinctes au moyen des au moins deux capteurs environnementaux (18, 20) dans un entourage de l'élément de manipulation tactile (12) ;
• mise à disposition des valeurs mesurées par l'intermédiaire des au moins deux influences environnementales à l'unité de commande et de calcul (14) comportant un programme de manipulation (16) ;
• sélection d'un calibrage de l'au moins un élément de manipulation tactile (12) selon les valeurs mesurées par l'intermédiaire des au moins deux influences environnementales au moyen de l'unité de commande et de calcul (14) comportant un programme de manipulation (16), de sorte que l'au moins un élément de manipulation tactile (12) est mis à disposition dans une plage de fonctionnement individuelle par rapport aux influences environnementales actuelles,
• relevé d'une position GPS d'un véhicule dans lequel sont disposés l'au moins un élément de manipulation tactile (12), les au moins deux capteurs environnementaux (18, 20) et l'unité de commande et de calcul (14) comportant un programme de manipulation (16) ;
• mise à disposition desdites informations concernant la position GPS relevée à l'unité de commande et de calcul (14) comportant un programme de manipulation (16), de sorte que lesdites informations sont prises en compte lors du calibrage, de sorte que l'au moins un élément de manipulation tactile (12) est mis à disposition dans une plage de fonctionnement individuelle par rapport aux influences environnementales actuelles et par rapport à la position GPS relevée.

2. Procédé selon la revendication 1, dans lequel l'au moins un élément de manipulation tactile (12) et les au moins deux capteurs environnementaux (18, 20) et l'unité de commande et de calcul (14) comportant un programme de manipulation (16) sont disposés dans un véhicule, en particulier dans un véhicule automobile.

3. Procédé selon la revendication 1, dans lequel l'au moins un élément de manipulation tactile (12) et les au moins deux capteurs environnementaux (18, 20) sont disposés dans un appareil électronique.

4. Procédé selon l'une des revendications précédentes, dans lequel l'un des au moins deux capteurs environnementaux (18, 20) mesure des valeurs de température dans l'entourage et dans lequel l'un des au moins deux capteurs environnementaux (18, 20) mesure des valeurs d'humidité de l'air dans l'entourage.

5. Procédé selon la revendication 4, dans lequel l'un des au moins deux capteurs environnementaux (18, 20) mesure des valeurs de température dans l'entourage et est disposé soit sur l'au moins un élément de manipulation tactile (12) et/ou soit dans une zone intérieure d'un véhicule.

6. Procédé selon l'une des revendications précédentes 1 à 2 ou 4 à 5, dans lequel le procédé comprend les étapes supplémentaires suivantes :
• relevé des caractéristiques suivantes d'un utilisateur respectif de l'au moins un élément de manipulation tactile (12) : âge, genre, taille, au moyen d'une caméra d'observation du conducteur ;
• mise à disposition desdites informations concernant les caractéristiques à l'unité de commande et de calcul (14) comportant un programme de manipulation (16), de sorte que lesdites informations sont prises en compte lors du calibrage, de sorte que l'au moins un élément de manipulation tactile (12) est mis à disposition dans une plage de fonctionnement individuelle par rapport aux influences environnementales actuelles, à la position GPS relevée et par rapport aux caractéristiques de l'utilisateur relevées.

7. Procédé selon l'une des revendications précédentes 1 à 2 ou 4 à 6, dans lequel le procédé comprend les étapes supplémentaires suivantes :
• interrogation d'un état d'un élément formant capteur de pluie et de luminosité d'un véhicule dans lequel sont disposés l'au moins un élément de manipulation tactile (12), les au moins deux capteurs environnementaux (18, 20) et l'unité de commande et de calcul (14) comportant un programme de manipulation (16) ;
• mise à disposition desdites informations concernant l'état actuel de l'élément formant capteur de pluie et de luminosité du véhicule à l'unité de commande et de calcul (14) comportant un programme de manipulation (16), de sorte que lesdites informations sont prises en compte lors du calibrage, de sorte que l'au moins un élément de manipulation tactile (12) est mis à disposition dans une plage de fonctionnement individuelle par rapport aux influences environnementales actuelles, à la position GPS relevée et par rapport aux caractéristiques de l'utilisateur relevées.

8. Procédé selon l'une des revendications précédentes, dans lequel l'unité de commande et de calcul (14) comportant un programme de manipulation (16) peut être réglée au moins partiellement de manière définie par l'utilisateur, de sorte que des influences environnementales respectives relevées conjointement peuvent être affectées de manière définie par l'utilisateur à des plages de fonctionnement individuelles respectives.

9. Système (10) permettant le calibrage dynamique d'éléments de manipulation tactiles (12) capacitifs par rapport à différentes influences environnementales, comprenant au moins un élément de manipulation tactile (12) couplé à une unité de commande et de calcul (14) comportant un programme de manipulation (16), au moins deux capteurs environnementaux (18, 20) distincts et respectivement couplés à l'unité de commande et de calcul (14) comportant un programme de manipulation (16), dans lequel l'unité de commande et de calcul (14) comportant un programme de manipulation (16) est configurée pour déterminer au moins un calibrage de l'au moins un élément de manipulation tactile (12), dans lequel le système (10) est configuré pour mesurer au moins deux influences environnementales distinctes au moyen des au moins deux capteurs environnementaux (18, 20) dans un entourage de l'élément de manipulation tactile (12), de sorte que lesdites valeurs mesurées par l'intermédiaire des au moins deux influences environnementales de l'unité de commande et de calcul (14) comportant un programme de manipulation (16) peuvent être mises à disposition, de sorte qu'un calibrage de l'au moins un élément de manipulation tactile (12) peut être sélectionné selon les valeurs mesurées par l'intermédiaire des au moins deux influences environnementales au moyen de l'unité de commande et de calcul (14) comportant un programme de manipulation (16), de sorte que l'au moins un élément de manipulation tactile (12) peut être mis à disposition dans une plage de fonctionnement individuelle par rapport aux influences environnementales actuelles, le système (10) est en outre configuré pour relever une position GPS d'un véhicule, et les informations concernant les informations GPS relevées peuvent être mises à disposition de l'unité de commande et de calcul (14) comportant un programme de manipulation (16), de sorte que la position GPS peut être prise en compte lors de la mise à disposition de la plage de fonctionnement individuelle de l'élément de manipulation tactile (12).
